# EUROPÄISCHE PATENTANMELDUNG

(11) **EP 1 094 527 A2**
(43) Veröffentlichungstag der Anmeldung: **25.04.2001**
(21) Anmeldenummer: 00126819.2
(22) Anmeldetag: 25.07.1994
(51) Int. Cl.: H01L 31/0236, H01L 27/142, H01L 21/306, H01L 23/367, H01J 37/04, B01J 35/04, B01D 46/12, B01D 29/00, G01N 27/00

(54) **Flaches Bauelement mit einem Gitternetz von Durchgangslöchern**

(30) Priorität: 29.07.1993 DE 4325407
(62) Teilanmeldung aus: 94921594.1
(71) Anmelder: Willeke, Gerhard, Dr., 79183 Waldkirch (DE); Fath, Peter, Dr., 78464 Konstanz (DE)
(72) Erfinder: Willeke, Gerhard, Dr., 79183 Waldkirch (DE); Fath, Peter, Dr., 78464 Konstanz (DE)
(74) Vertreter: Pietruk, Claus Peter, Dipl.-Phys.

(57) **Zusammenfassung**

Die Erfindung betrifft ein Verfahren zur Herstellung eines flachen Bauelements mit einem Gitternetz von Durchgangslöchern (7). Die Durchgangslöcher (7) entstehen dadurch, daß auf der Vorder- und Rückseite eines scheibenförmigen Grundkörpers je eine Vielzahl, vorzugsweise äquidistanter, paralleler, insbesondere V-förmiger Gräben (8) eingearbeitet sind, wobei die Gräben (8) der beiden Seiten relativ zueinander einen Winkel einschließen und jeweils so tief sind, daß an den Kreuzungspunkten der Gräben (8) automatisch die Durchgangslöcher (7) entstehen. Die Erfindung betrifft außerdem die Verwendung des erfindungsgemäßen Bauelements als Hochleistungssolarzellen sowie Verfahren zur Herstellung einer derartigen Solarzelle, seine Verwendung als Mikrofilter, als Mikrosieb, als Katalysatorgrundkörper, als Beschleunigungsgitter für geladene Teilchen und zur Beeinflussung des Strömungsverhaltens von umströmten Körpern.

## Beschreibung

Die Erfindung betrifft ein Verfahren zur Herstellung eines flachen Bauelements mit einem Gitternetz von Durchgangslöchern und ein solches Bauelement.

In vielen Bereichen der Technik kommen Bauelemente zum Einsatz, die eine regelmäßige Anordnung von Durchgangslöchern aufweisen. Dabei dienen die Löcher als Durchlaßöffnungen für Gas- und Flüssigkeitsströme (Filter- und Strömungstechnik sowie Sensorik), geladene Teilchen (Ionen- oder Elektronenoptiken) und elektromagentische Strahlung (IR- und VIS Optik) oder zur elektrischen Verbindung zwischen der Vorder- und Rückseite einer Halbleiterscheibe (Mikroelektronik und Photovoltaik). Zur Erzeugung einer regelmäßigen Anordnung von Löchern in einem scheibenartigen Grundkörper kommen gegenwärtig verschieden Verfahren zum Einsatz, je nach vorliegenden Material und Abmessungen der zu erzeugenden Öffnungen. Liegen die Durchmesser der Löcher im Millimeterbereich und größer so werden mechanische Verfahren wie Bohren oder Fräsen verwendet. Mit Hilfe von Funkenerosion können Löcher in leitenden Materialien bis in den 100µm Bereich erzeugt werden. Zur Herstellung von Löchern in Metallen, Keramiken und Halbleitern mit Abmessungen von 10µm und größer kommen feinfokussierte gepulste Laser zum Einsatz. Mit Öffnungen in der gleichen Größenordnung lassen sich Gitter direkt durch galvanischen oder stromloses Abscheiden von Metallen auf mit entsprechenden Masken versehenen Grundkörpern erzeugen oder durch Pressen oder Walzen von duktilen Metall- oder Kunststoffolien auf Formkörpern mit dem dazugehörigen Negativprofil. Speziell bei Vorliegen von spröden Materialien wie Keramiken und Halbleitern kann auf Ultraschallbohren zurückgegriffen werden. Zur Erzeugung von Löchern im µm und sub-µm Bereich in Metallen und Halbleitern sind photolithographische Methoden in Kombination mit Ätztechniken besonders geeignet.

Aufgabe des vorliegenden Erfindung ist daher die Bereitstellung eines Verfahrens zur Herstellung von Gitternetzen mit regelmäßig angeordneten Durchgangslöchern, bei dem im Vergleich zu bisherigen Methoden eine große Vielfalt bzgl. Gitteraufbau, Art der zu bearbeiteten Materialien und Variation des Durchmessers der Durchgangslöcher gewährleistet ist.

Diese Aufgabe wird bei einem Verfahren der eingangs genannten Art dadurch gelöst, daß auf der Vorder- und Rückseite eines scheibenförmigen Grundkörpers je eine Vielzahl, vorzugsweise äquidistanter, paralleler, insbesondere V-förmiger Gräben derart eingearbeitet werden, daß die Gräben der beiden Seiten relativ zueinander einen Winkel einschließen und jeweils so tief sind, daß an den Kreuzungspunkten der Gräben von Vorder- und Rückseite automatisch die Durchgangslöcher entstehen.

Mit dem erfindungsgemäßen Verfahren lassen sich flache Bauelemente herstellen, die in vielen verschiedensten Gebieten gegenwärtiger technischer Betätigung eingesetzt werden können. De Abstand der Gräben untereinander, der Winkel, den die Gräben einer Seite untereinander sowie die Gräben der Vorder- und Rückseite relativ zueinander einschließen, die Grabenform und Grabentiefe, bestimmen den prinzipiellen Aufbau des Gitters und legen insbesondere die Anordnung, Form und Größe der Löcher fest. Aufgrund der Die großen Anzahl dieser frei wählbaren Parametern und der Vielzahl der bearbeitbaren Materialien bietet das erfindungsgemäße Verfahren eine überlegene Gestaltungsvielfalt bei der Herstellung gitterartiger Bauelemente.

Bei einer bevorzugten Ausführungsform werden die Gräben mechanisch, insbesondere mittels eines schnell rotierenden, mit angeschrägten Profilen versehenen Sägeblattes, in den Grundkörper eingebracht. Diese Verfahren ist vor allem im Hinblick auf die Universalität der bearbeitbaren Materialien und die mögliche Vielfalt bei der Ausgestaltung von Gräben und Durchgangslöcher und damit der Gitternetzstrukturen von Vorteil. Die hohe Genauigkeit bei der Anwendung von Sägemaschinen gewährleistet die Herstellung von Gitter mit entsprechend hoher Präzision. Durchmesser der Durchgangslöcher von bis zu 5µm sind speziell bei Verwendung angeschrägter Sägeblätter möglich, wobei der minimale Lochdurchmesser lediglich durch die Korngröße des Abriebmittels der Sägeblätter begrenzt wird.

Durch die Montage mehrerer Sägeblatter auf einer Spindel kann der Produktionsdurchsatz gesteigert werden.

Die Gräben können auch mit einem anderen mechanischen Verfahren, insbesondere mittels eines schnell rotierenden Sägeformkörpers eingebracht werden. Der Sägeformkörper besteht in diesem Fall aus einem walzenförmigen Grundkörper, der das Negativprofil der Gräben aufweist und mit einem Abriebmittel überzogen ist. Die Verwendung einer solchen Strukturierwalze ermöglicht einen hohen Produktionsdurchsatz von Gittern, und hat die Vorteile der aufwendigen Montage und der relativ geringen Kosten im Vergleich zu Sägeblättern. Der walzenförmigen Grundkörper kann aus Metall (z.B. weiche Stähle, Aluminium, Bronze, usw.) bestehen, es sind aber auch andere Materialien , insbesondere Keramiken und Spezialkunststoffe denkbar. Schließlich ist auch eine direkte Herstellung einer Strukturwalze aus dem entsprechenden Abriebmittel, beispielsweise Diamant, Bornitrid, Siliziumcarbid, usw., denkbar.

Die Erfindung betrifft auch ein flaches Bauelement mit einem Gitternetz aus Durchgangslöchern, die dadurch entstehen, daß auf der Vorder- und Rückseite eines scheibenförmigen Grundkörpers je eine Vielzahl, vorzugsweise äquidistanter, paralleler, insbesondere V-förmiger Gräben eingearbeitet sind, und daß die Gräben der beiden Seiten relativ zueinander einen Winkel einschließen und jeweils so tief sind, daß an den Kreuzungspunkten der Gräben automatisch die Durchgangslöcher entstehen.

Bei einer Variante des erfindungsgemäßen Bauelements ist vorgesehen, daß mehrere solcher Gitternetz übereinander geschichtet sind, wodurch sich das potentielle Einsatzgebiet des Bauelements weiter vergrößert. Die Gitternetze können dabei so angeordnet sein, daß bei zwei oder mehreren der Gitternetze die Gräben der Rückseite des vorhergehenden Gitters unter einem vorzugsweise senkrechten Winkel relativ zur Ausrichtung der Gräben auf der Vorderseite des nachfolgenden Gitters orientiert sind. Diese Anordnung ermöglicht eine gezielte Veränderungen der Durchgangsöffnungen bei vorgegebener Größe der Durchgangslöcher in den einzelnen Gitternetzen .

Es ist ebensogut möglich, daß bei zwei oder mehreren der Gitternetze die Gräben der Rückseite des vorhergehenden Gitters parallel zu der Ausrichtung der Gräben auf der Vorderseite des nachfolgenden Gitters orientiert sind, so daß die Gräben des vorhergehenden Gitters den nachfolgenden Grabenspitzen als Führungsnuten dienen.Auf der Basis eines solchen Bauelements sind Mirkokühler und Mikrowärmetauscher herstellbar.

Eine andere Variante des Bauelements sieht vor, daß sich zwischen zwei oder mehreren Gitternetzen ein scheibenförmiger Grundkörper ohne Durchgangslöcher befindet.

Bei einer weiteren Ausführungsform des erfindungsgemäßen Bauelements sind die Gräben an Rückseite des Grundkörpers miteinander verbundenen. Erfindungsgemäß wird diese Ausführungsform dazu verwendet, das Strömungsverhalten eines umströmten Körpers zu beeinflussen. Das strömende Medium wird mittels der Durchgangslöcher und der Gräben auf der dem Medium abgewandten Rückseite der einzelnen Gitternetze abgesaugt oder injiziert.

Es ist möglich, das erfindungsgemäße Bauelements als Hochleistungssolarzelle zu verwenden. Zu diesem Zweck kann das erfindungsgemäße Bauelement auf der Grundlage einer kristallinen Siliziumscheibe hergestellt sein und auf der Vorder- und Rückseite mit Ausnahme der Kontaktzonen eine ganzflächig ausgebildete Emitterbeschichtung aufweisen, wobei die Emitterschicht der Vorderseite mit der Emitterschicht der Rückseite über die Durchgangslöcher in elektrischer Verbindung steht.

Bei Verwendung von multikristallinen Siliziumscheiben als Ausgangsmaterial zur photovoltaischen Energiegewinnung sind die üblicherweise relativ geringe Diffusionslänge der Minoritätsladungsträger sowie der kleine Absorptionskoeffizient des Siliziums Hindernisse zur Erzielung eines hohen Wirkungsgrades. Insbesondere bei den modernen kostengünstigen Plattengießverfahren werden verfahrenstechnisch bedingt nur relativ kleine Kristallitgrößen und somit Diffusionslängen erreicht.

Um die beiden Hauptursachen der kleinen Diffusionslänge der Minoritätsladungsträger, Rekombination an Korngrenzen und Verunreinigungen, zu mindern, werden die multikristallinen Si-Substrate im Verlauf des Solarzellenproduktionsprozesses einer Behandlung mit Wasserstoff und/oder eines Phosphorgetterschrittes unterzogen [1], [2]. Die erzielten Ergebnisse sind aber in der Regel beschränkt. Deshalb wird hauptsächlich versucht, durch Verbesserung des üblichen Blockgußverfahrens möglichst grobkristallines, reines Material zu bekommen.

Um das Problem des kleinen Absorptionskoeffizients von Silizium zu lösen, wurden in der Vergangenheit verschiedene Verfahren zur besseren Einkopplung des einfallenden Lichtes entwickelt.

Derzeit finden neben dem Auftragen von Antireflex-Beschichtungen vor allem Methoden Anwendung, bei denen die Oberfläche des Siliziumsausgangsmaterials strukturiert wird.

Bei monokristallinem Silizium werden unter Zuhilfenahme des anisotropen Ätzverhaltens organischer sowie alkalischer Ätzlösungen und gegebenenfalls in Kombination mit vorausgehenden photolithographischen Verfahrensschritten unregelmäßig verteilte Pyramiden, geordnete Muster aus invertierten Pyramiden [3], lamellenartige Strukturen [4] oder V-förmige Gräben [5] erzeugt.

Aufgrund der unregelmäßigen Verteilung von Kristalliten verschiedenster Kristallorientierung in multikristallinen Siliziumscheiben zeigen die genannten Verfahren nur sehr unbefriedigende Resultate. Als alternative Strukturierungsmethoden wurden nach dem Stand der Technik Oberflächentexturierungen mit Hilfe von Lasern [6] oder konventionellen Siliziumwafer-Sägen, bestückt mit unangeschrägten oder angeschrägten Trenn-Sägeblättern [7] [8] durchgeführt. Die Oberflächentextur wurde jeweils auf der dem Sonnenlicht zugewandten Seite der Solarzelle durchgeführt.

Es ist so erstmals möglich, eine Hochleistungssolarzelle aus kristallinen, insbesondere feinkristallinen direkt gegossenen Siliziumscheiben bereitzustellen, und zwar trotz der relativ kleinen Diffusionslänge der Minoritätsladungsträger in multikristallinem Silizium und des kleinen Absorptionskoeffizients in diesen Materialien. Es kann eine Hochleistungssolarzelle hergestellt werden
- aus monokristallinen Siliziumscheiben sowie aus multikristallinem Siliziumausgangsmaterial von strukturell und elektronisch minderer Qualität,
- mit einem einfachen Herstellungsverfahren unter Zuhilfenahme eines schnell rotierenden Säge-Formkörpers, ausgestattet mit spitz zulaufenden Profilen, und nur wenigen folgenden Prozeßschritten,
- mit hohem Wirkungsgrad bei der photovoltaischen Energieumwandlung,
- mit Lichtempfindlichkeit beider Seiten der Zelle,
- bei niedrigem Gewicht,
wobei die erhaltene Solarzelle steuerbar lichtdurchlässig ist.

Aufgrund der genannten Vorteile ist die Hochleistungssolarzelle aus kristallinen Siliziumscheiben auf Basis des erfindungsgemäßen Verfahrens für einen großflächigen terrestrischen Einsatz bestens geeignet. Interessant erscheint außerdem eine mögliche Anwendung dieser Technologie auf monokristallinem Silizium für den extraterrestrischen Gebrauch unter besonderer Berücksichtigung des Gewichtsvorteils und der zu erwartenden guten Strahlungstoleranz.

Weitere spezielle Einsatzgebiete ergeben sich bei Ausnutzung der durch die Lochgröße regelbaren Lichttransparenz. So kann die Solarzelle sowohl bei Fensterabdeckungen im Geschäftsbereich und im privaten Sektor als auch in Sonnendächern von Kraftfahrzeugen eingesetzt werden oder als integraler Baustein von Fassadenverkleidungen dienen.

Bei einer bevorzugten Ausführungsform der Hochleistungssolarzelle auf Basis des erfindungsgemäßen Verfahrens sind die Oberfläche(n) der Solarzelle ganzflächig, mit Ausnahme der Kontaktzonen passiviert. Die Stege zwischen den Gräben können in alternierender Reihenfolge mit einer n⁺⁺- bzw. p⁺⁺-Diffusion versehen sein.

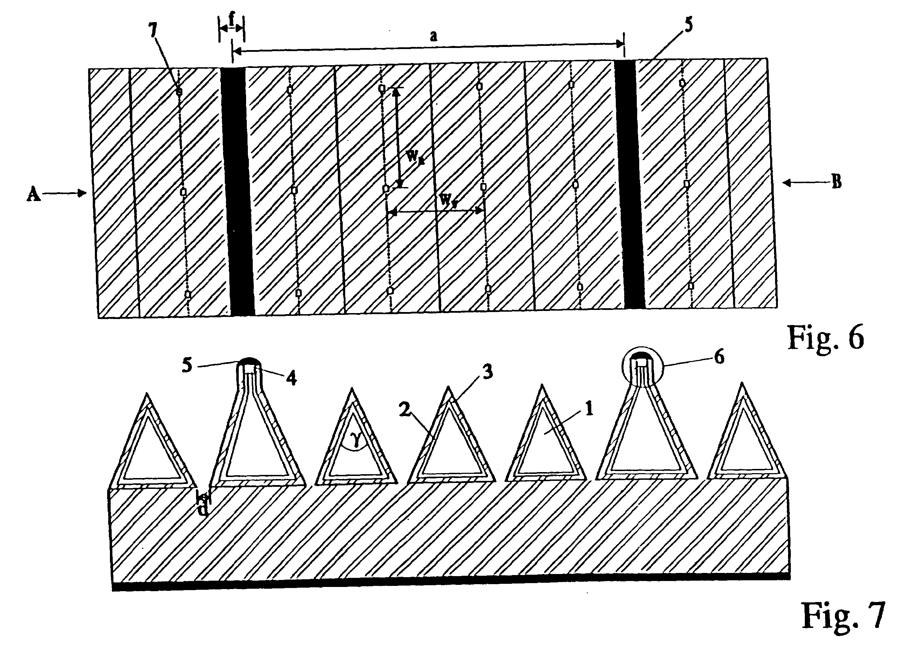

Bei einer besonders vorteilhaften Variante der Solarzelle auf Basis des erfindungsgemäßen Verfahrens sind die Gräben auf der Rückseite der Solarzelle derart angeordnet, daß sie alternierend an ihrem einen bzw. anderen Ende mit dem jeweils benachbarten Graben eine spitzen Winkel einschließen, so daß ein durchgängiger Graben mit einem Zick-Zack-Verlauf ausgebildet ist und die dazwischen befindlichen Stege an ihrem dem Grabenwinkel zugewandten Ende spitz zulaufen. Bei Durchführung einer Kontaktfingerdiffusionen, bei der die lateral spitz zulaufenden Siliziumstege einer Seite mit einer n⁺⁺-Diffusion (Abb. 6 (2)) und die Stege der gegenüberliegenden Seite mit einer p++-Diffusion (Abb. 6 (3)) versehen werden, wird eine für Rückkontakt-Solarzellen vorteilhafte Kontaktfingeranordnung von ineinander verzahnten Kontakten alternierenden Ladungsträgertypes (n++-p++-n++) erzielt. An dem (jeweils) äußeren Rand der Rückseite der Solarzelle kann eine Hauptleiterbahn ausgebildet sein, wodurch die elektrische Verbindung von einzelnen Konataktfingern gleichen Ladungsträgertypes, insbesondere bei der vorliegenden Kontaktfingeranordnung, stark vereinfacht wird. Mit dem oben genannten Kontaktierungsschema ist es möglich, Rückkontakt-Solarzellen auf einfache Art und Weise herzustellen, bei denen sich die stromabführenden Metallkontakte vollständig auf der Rückseite befinden. Diese Anordnung hat den Vorteil des Nichtauftretens von Reflexionsverlusten im Vergleich zu einer Zellmetallisierung auf der Vorderseite.Realisierbar ist auch ein Verfahren zur Kontaktierung der erfindungsgemäßen Solarzelle, das dadurch charakterisiert ist, daß die zwischen den Gräben verlaufenden, herausragenden Stege metallisiert werden.Vorzugsweise beinhaltet dieses Verfahren, daß ein walzenartiger Körper, der mit einer metallhaltigen Paste überzogen ist, über die herausragenden Stege gerollt wird. Mit diesem Walzendruckverfahen können darüberhinaus dotandenhaltige Pasten zur selektiven Kontaktdiffusion (n++ und p++) sowie Ätzmittel zur selektiven Öffnung eines Passivierungsoxids oder - nitrids aufgetragen werden.Bei einer besonders bevorzugten Variante des erfindungsgemäßen Kontaktierungsverfahrens wird ein photosensitiver Lack aufgebracht, dieser Lack unter einem vorzugsweise kleinen Winkel schräg belichte, nachfolgend der belichtete Lack entfernt, und anschließend innerhalb der dadurch erzeugten Öffnungen an der Oberseite der Gräben eine Metallisierung vorgenommen.Vor der Metallisierung der Kontaktbahnen sollte eine starke n-Typ bzw. p-Typ Diffusion in den Bereichen der Kontaktbahnen vorgenommen werden.Falls gewünscht oder gar notwendig, können die metallisierten Kontaktbahnen auch ausschließlich auf der Rückseite der Solarzellen ausgebildet sein.

Bei dem beschriebenen Bauelement kann also vorgesehen sein, daß die Gräben 8 auf der Rückseite miteinander verbunden sind. Es kann auch vorgesehen sein, daß zur Verwendung als Hochleistungssolarzelle auf der Grundlage einer kristallinen Siliziumscheibe die Vorder- und Rückseite der Solarzelle mit Ausnahme der Kontaktzonen eine ganzflächig ausgebildete Emitterschicht aufweisen, und daß die Emitterschicht der Vorderseite mit der Emitterschicht der Rückseite über die Durchgangslöcher in elektrischer Verbindung steht, wobei auch möglich ist, daß die Oberfläche(n) der Solarzelle ganzflächig, mit Ausnahme der Kontaktzonen passiviert ist(sind) und/oder daß die Stege zwischen den Gräben in alternierender Reihenfolge mit einer n++- bzw. p++-Diffusion versehen sind und/oder daß die Gräben auf der Rückseite der Solarzelle alternierend an ihrem einen bzw. anderen Ende mit dem jeweils benachbarten Graben einen spitzen Winkel einschließen, so daß die dazwischen befindlichen Stege an ihrem dem Grabenwinkel zugewandten Ende spitz zulaufen, wobei insbesondere möglich ist, daß an dem (jeweils) äußeren Rand der Rückseite der Solarzelle eine Hauptleiterbahn ausgebildet ist, und/oder daß die zwischen den Gräben verlaufenden, herausragenden Stege metallisiert werden, wobei bevorzugt ist, wenn ein walzenartiger Körper, der mit einer metall-, dotanden- oder ätzmittelhaltigen Paste überzogen ist, über die herausragenden Stege gerollt wird oder in alternativer Bevorzugung ein photosensitiver Lack aufgebracht wird, wobei vorgesehen sein kann daß der Lack unter einem vorzugsweise kleinen Winkel schräg belichtet wird, daß nachfolgend der belichtete Lack entfernt wird, und daß innerhalb der dadurch erzeugten Öffnungen an der Oberseite der Gräben eine Metallisierung vorgenommen wird, wobei weiter bevorzugt ist, daß der Metallisierung der Kontaktbahnen eine starke n-Typ bzw. p-Typ Diffusion in den Bereichen der Kontaktbahnen vorausgeht und es möglich und bevorzugt ist, daß sich die hergestellten metallisierten Kontaktbahnen vollständig auf der Rückseite der Solarzellen befinden.

Die Erfindung betrifft neben dem Verfahren und seiner möglichen Anwendung auf Solarzellen und diese integrierende Fassadenverkleidungen des weiteren insbesondere die Verwendung des erfindungsgemäßen Bauelements als Mikrofilter, wobei mehrere Gitternetze übereinander geschichtet sind und/oder die Flußrichtung des zu filternden flüssigen oder gasförmigen Mediums unter einem vorzugsweise senkrechten Winkel zur Gitterebene verläuft.

Die Erfindung betrifft desweiteren die Verwendung des erfindungsgemäßen Bauelements als Mikrokühler bzw. Mikrowärmetauscher, wobei ein oder mehrere Gitternetze verwendet werden können und/oder der Kühlmittelfluß längs der Gräben verläuft.

Die Erfindung betrifft gleichfalls die Verwendung des erfindungsgemäßen Bauelements als Mikrosieb, wobei der Partikelfluß unter einem vorzugsweise senkrechten Winkel zur Gitterebene verläuft. In diesem Anwendungsfall sind mehrere Gitternetze derart übereinander geschichtet, daß der Durchmesser der Durchgangslöcher der einzelnen Scheiben von der Vorderzur Rückseite des Filters abnimmt, so daß bei einem Trägergas- oder einem Trägerflüssigkeitsfluß senkrecht zur Filterebene durch die entsprechenden Gräben eine Selektion der Partikel nach Größe erfolgt.

Die Erfindung betrifft zudem die Verwendung des erfindungsgemäßen Bauelements als Katalysatorgrundkörper, wobei mehrere Gitternetze übereinandergeschichtet sind und die einzelnen Gitternetze aus der katalytisch wirksamen Substanz bestehen und/ oder mit dieser beschichtet sind.

Die Erfindung betrifft ebenfalls die Verwendung des erfindungsgemäßen Bauelements als grundkörper für gas-, Flüssigkeits- oder Partikelsensoren, bei denen die Gräben als Justierhilfe zur Befestigung von optischen Glasfasern oder Mikrokanülen verwendet werde. Dabei kann das Licht von Lasern, das an einer Seite des Bauelements längs eines oder mehrerer Gräben der Oberseite mit Hilfe von Glasfasern eingestrahlt wird, dazu verwendet werden, Gas-, Flüssigkeits- oder Partikelströme, die mittels der Durchgangslöcher von den Gräben der Unterseite in die Gräben der Oberseite injiziert werden, zu detektieren.

Die Erfindung betrifft fernerhin die Verwendung des erfindungsgemäßen Bauelements als Gitter zur Beschleunigung geladener Teilchen.

In der Halbleiter- und Dünnschichttechnik werden Oberflächen oft mit Hilfe eines Ionenstrahls bearbeitet. Dazu werden Atome vorzugsweise eines Elements ionisiert und anschließend in einem elektrischen Feld auf die gewünschte kinetische Energie beschleunigt und je nach Anforderung fokussiert. Mit Hilfe eines solchen Ionenstrahls lassen sich an einer Festkörperprobe Prozesse wie z.B. Oberflächenreinigung oder - strukturierung, Ionenimplantation oder ionenstrahlunterstütztes Schichtwachstum durchführen.

Ionenkanonen, also Geräte zur Herstellung von Ionenstrahlen, werden in verschiedenen Ausführungen und Funktionsweisen angeboten. Sie unterscheiden sich in der Art, wie die Ionen erzeugt, beschleunigt und anschließend fokussiert werden. Die Beschleunigung der Ionen läßt sich z.B. durch Lochblenden oder durch Gitter bewerkstelligen, die auf einem entsprechenden elektrischen Potential liegen. Die Bauteile unterscheiden sich in Geometrie und Eigenschaften.

Herkömmlicherweise bestehen solche Gitter aus feinen Metallgeweben oder vielfach gebohrten Metall- oder Graphitfolien. Neuere Entwicklungen gehen dahin, mit Hilfe anisotroper Ätzverfahren Siliziumgitter herzustellen, und diese in HF-Plasma Ionenstrahlquellen einzusetzen. Durch die Verwendung von zwei hintereinander geschalteten Gittern lassen sich dabei die Ionen großflächig, mit niedriger Energie und hoher Intensität aus dem HF-Plasma extrahieren. Eine solche Quelle ist z.B. in dem Artikel "Integrated silicon grid ion extraction system for O2 processes" (Journal of Vacuum Science Technology, B8(6), S.1716-1720) beschrieben.

Eine ungünstige Eigenschaft von Ionenstrahlen, die mit Hilfe von Gittern beschleunigt werden, ist ihre Verunreinigung durch Gittermaterial. Diese kommt durch den Ionenbeschuß der Gitteroberfläche und dem damit verbundenen Materialabtrag zustande. Selbst geringe Anteile von Fremdmaterial im Ionenstrahl können empfindliche Prozesse auf der Probe stören. Dies ist als wesentlicher Nachteil von Ionenstrahlquellen anzusehen, die mit Metallgittern arbeiten und in Halbleiterprozessen eingesetzt werden. Die Patentschrift EP 40 58 55 verdeutlicht dieses Problem: Bei der dort beschriebenen Ionenquelle zur MOSFET-Herstellung werden alle Teile, die mit dem Ionenstrahl in Berührung kommen, aus Reinstsilizium hergestellt, um Kontamination zu vermeiden.

Der negative Einfluß von Verunreinigungen im Ionenstrahl, verursacht durch ein Gitter, läßt sich reduzieren, wenn Gitter und Probe aus dem gleichen Material sind. Bei der o.g. HF-Plasma Ionenstrahlquelle ist dies beim Einsatz in der Siliziumntechnologie erfüllt. Die hier verwendeten anisotrop geätzten Siliziumgitter haben allerdings den Nachteil, daß bei ihrer Herstellung hohe Kosten anfallen. Die durchzuführenden photolithographischen Methoden sind sehr arbeitsintensiv und stellen hohen Anforderungen an die benötigten Geräte (z.B. Photolithographiegeräte, Reinraumausstattung, Ätzanlagen).

Mit dem erfindungsgemäßen Verfahren, ist es möglich, Gitter zur Beschleunigung geladener Teilchen bereitzustellen, die aus unterschiedlichen, dem jeweiligen Prozeß angepaßten Materialien hergestellt werden können und sich durch einfache Fertigungsverfahren auszeichnen.

Für diesen Anwendungsfall sollten die Gräben auf Vorder- und Rückseite des erfindungsgemäßen Bauelements einen trapezförmigen Querschnitt aufweisen. Diese Grabenform ermöglicht es, die Transparenz unabhängig von der Form der Gitterstege zu vergrößern. Durch die Wahl des Flankenwinkels der Gräben kann die Lage der Äquipotentialflächen und damit der spätere Feldlinienverlauf beeinflußt werden. Besonders vorteilhaft ist es, wenn das Bauelement eine sehr hohe Transparenz besitzt.

Der wesentliche Vorteile dieser erfindungsgemäßen Gitter zur Teilchenbeschleunigung besteht darin, daß die Materialbeschaffenheit der Gitter für die Herstellung unwesentlich ist und dem späteren Einsatz angepaßt werden kann. Störungen durch Verunreinigungen im Ionenstrahl, die bisher den Einsatz von Gittern in bestimmten Ionenstrahlquellen generell ausgeschlossen haben, können so vermieden werden. Die Lage der Äquipotentialflächen kann bei der Herstellung beeinflußt werden, was u.U. für die Fokussierung der geladenen Teilchen ausgenutzt werden kann. Das zur Herstellung der Gitter angewandte Verfahren ist vergleichsweise einfach und stellt nur geringe Anforderungen an Material und Gerät.

Die Erfindung betrifft schließlich die Anwendung des erfindungsgemäßen Bauelements im Bereich der Strömungstechnik. Dabei sind aerodynamische wie auch hydrodynamische Anwendungen denkbar.

Beispielsweise bei Tragflächen eines Flugzeugs werden mit Hilfe eines Laserstrahls bzw. eines Elektronenstrahls Löcher mit einem Durchmesser von ca. 40mm in eine Platte eingebracht, um die Grenzschicht abzusaugen und damit die Strömungseigenschaften zu verbessern. Diese Platten werden auf der restlichen Tragkonstruktion aufgebracht, wobei die Konstruktion zusätzlich als große Absaugvorrichtung ausgelegt werden muß.

Die beschriebene Technik hat die Nachteile eines hohen technischen und zeitlichen Aufwands. Zusätzlich sind die Kosten hoch, da nahezu die gesamte Tragfläche als Absaugvorrichtung verwendet wird.

Die Entstehung einer turbulenten Strömung hinter dem Ablösungspunkt einer laminaren Strömung eines umströmten Körpers kann durch eine homogene Absaugung weiter nach hinten verlagert bzw. ganz verhindert werden. Je homogener bzw. kontinuierlicher diese Absaugung ist desto kleiner muß die Absaugmenge sein. Mit Hilfe eines erfindungsgemäßen Bauelements, bei dem die Gräben auf der Rückseite des Grundkörpers miteinander verbunden sind, kann eine homogene und definierte Absaugung erfolgen, wobei die strukturierte Schicht als Teil der Absaugvorrichtung verwendet werden kann. Dabei werden die Strukturen des Gitters, welche dem umströmten Körper zu- und dem strömenden Medium abgewandt sind als Kanäle verwendet, die das Medium von der Oberfläche weg, zu größeren Absaugstrukturen, welche teilweise ebenfalls in die Gitterstruktur eingebracht werden können, hin transportieren. Da entlang eines Kanals ein Druckverlust entsteht kann durch geeignetes variieren der Lochgröße entlang eines Kanals die Absaugung homogen gehalten werden. Die Technik kann jedoch auch verwendet werden um einen frühzeitigen Strömungsabriss zu erzwingen, indem das Medium nicht von der Oberfläche des umströmten Körpers abgesaugt wird, sondern ein umgekehrter Prozeß, eine Injektion eines Mediums an die Oberfläche, eingesetzt wird. Beide Prozesse können mit der gleichen Struktur angewandt werden. Dabei wäre denkbar beide Prozesse gleichzeitig an verschiedenen Punkten der Oberfläche einzusetzen.

Der oben beschriebene Effekt der Grenzschichtbeeinflussung durch Absaugung und Injektion von einem Medium kann auch zur Steuerung der Bewegungsrichtung verwendet werden, wenn die Vorrichtung auf zwei oder mehreren Seiten des Körpers angebracht ist. Dadurch läßt sich die Seite und Stärke des Niederdrucks beliebig einstellen und somit die Richtung der Bewegungskräfte steuern.

Die Erfindung wird im folgenden anhand von Ausführungsbeispielen, die teilweise in den Zeichnungen dargestellt sind, näher erläutert. Es zeigen
- Fig. 1:: ein Trennsägeblatt mit abgeflachtem Profil und einem Spitzwinkel
- Fig. 2:: Schnittzeichnungen zweier Strukturwalzengrundkörper
- Fig. 3:: eine Darstellung des Walzendruckverfahrens
- Fig. 4:: eine Strukturwalze mit unprofiliertem, glatten Grundkörper
- Fig. 5:: eine perspektivische Schnittzeichnung einer fertig prozessierten Solarzellen gemäß Ausführungsvariante I
- Fig. 6:: eine Aufsicht auf einen Ausschnitt einer Solarzelle gemäß Ausführungsvariante I
- Fig. 7 :: Querschnitt durch eine Solarzellen gemäß Ausführungsvariante I in Schnittrichtung A-B von Fig.6
- Fig. 8:: eine perspektivische Schnittzeichnung einer fertig prozessierten Solarzellen gemäß Ausführungsvariante II
- Fig. 9:: eine Aufsicht auf einen Ausschnitt einer Solarzelle gemäß Ausführungsvariante II
- Fig. 10 :: Querschnitt durch eine Solarzellen gemäß Ausführungsvariante II in Schnittrichtung A-B von Fig.9
- Fig. 11 :: Aufsicht auf die Rückseite einer Solarzelle gemäß Ausführungsvariante III,
- Fig. 12:: Darstellung des Walzendruckverfahrens zur Kontaktfingermetallisierung,
- Fig. 13:: eine perspektivische Zeichnung des beschriebenen Belichtungsvorganges,
- Fig. 14:: eine perspektivische Zeichnung des dargestellten Metallaufdampfprozesses,
- Fig. 15:: eine Darstellung des erfindungsgemäßen Bauelements als Gitter zur Beschleunigung geladener Teilchen
- Fig. 16: eine Darstellung eines in der Strömungstechnik eingesetzten erfindungsgemäßen Bauelements
- Fig. 17:: Querschnitt (a, b) und Aufsicht (c) auf die zum umströmten Körper weisende Oberfläche des Bauelements nach Fig. 16.
- Fig. 18:: eine Prinzipdarstellung zur Erläuterung der Einkopplung von Photonen in eine Solarzelle nach den Figuren 5...14

### Beispiel 1

### Herstellung des erfindungsgemäßen Bauelements mit Gitter

Bringt man in den scheibenförmigen Grundkörpers äquidistante, parallel zueinander verlaufende Gräben 8 ein, wobei die Gräben 8 der Vorder- und Rückseite einen Winkel von 90° einschließen und den gleichen Abstand untereinander aufweisen, so erhält man ein Gitternetz mit quadratischer Einheitszelle der Löcher 7. Unterscheiden sich der Abstand der Gräben 8 auf der Vorder- und Rückseite, so ist die Einheitszelle rechtwinkeliger Natur. Schließen die Gräben 8 beider Seiten einen Winkel ungleich 90° ein, so erhält man als Grundelemente des Gitters Parallelogramme. Läßt man die Gräben 8 einer oder beider Seiten einen Winkel zueinander einschließen, so kann man neben Trapezen oder Dreiecken als Einheitszellen weitgehend beliebige Anordnungen von Löchern innerhalb des Gitternetzes erzeugen. Die Größe und Form der Löcher 7 wird bei Vorliegen einer rechtwinkeligen Grabenform direkt durch die Breite der Gräben 8 der Vorder- und Rückseite festgelegt. Gräben 8 gleicher Breite auf beiden Seiten des scheibenförmigen Grundkörpers generieren an ihren Kreuzungspunkten quadratische Löcher 7 mit der Grabenbreite als Kantenlänge. Bei unterschiedlicher Grabenbreite erzeugt man rechtwinkelige Lochformen. Verwendet man V-förmige Grabenprofile, so erhält man rautenförmige Löcher 7, deren Größe mit der Tiefe der Gräben 8 auf Vorder- und Rückseite zunimmt. Verrundete Grabenprofile ermöglichen runde Lochformen. Der Bedeckungsgrad der Lochfläche relativ zur Gesamtscheibenfläche kann durch den Grabenabstand und durch die Lochgröße über weite Bereiche je nach Anwendung beliebig eingestellt, wobei eine obere Grenze lediglich durch die erforderliche mechanische Stabilität des Bauelementes vorgegeben wird.

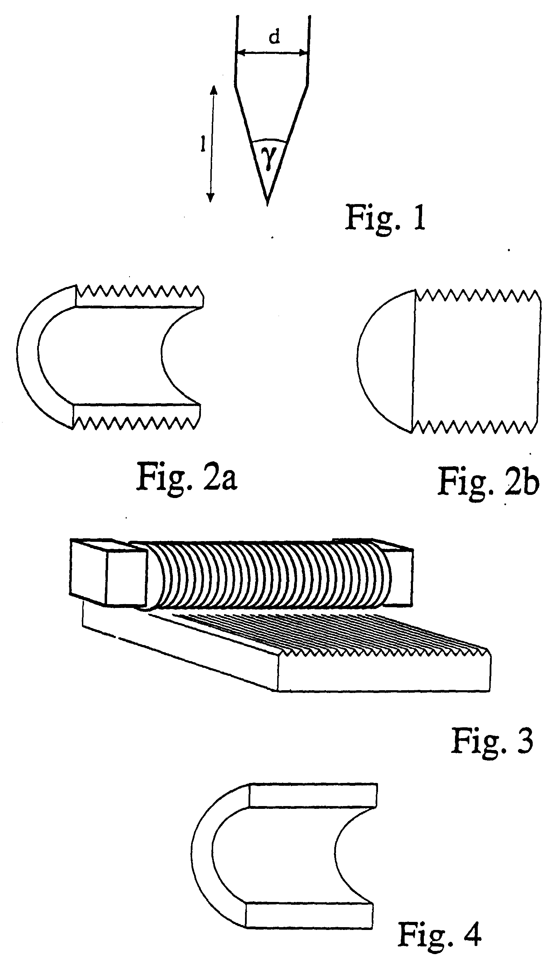

Mögliche Verfahren zur Erzeugung der Gräben 8 richten sich nach der Art der verwendeten Materialien und den Abmessungen der zu erzeugenden Gitternetze:
a) Auf Metalle und Halbleiter gleichermaßen gut anwendbar ist das Einbringen der Gräben 8 mit Hilfe von Lasern im ungepulsten Betrieb. Dadurch können Gräben 8 mit minimalen Breiten im Bereich von 10µm erzeugt werden.
b) Bei Verwendung von monokristallinen Halbleitermaterialien, insbesondere Silizium, als Grundmaterial des Gitters können unter Ausnutzung des anisotropen Ätzverhaltens alkalischer und organischer Ätzmittel und unter Einbeziehung photolithographischer Arbeitsschritte Gräben 8 speziell mit V-Profil in den scheibenförmigen Grundkörper eingearbeitet werden.
c) Bei der mechanischen Einarbeitung unter Verwendung schnell rotierender Sägeformkörpern werden kommerziell erhältliche scheibenförmige Sägeblätter auf einer schnell rotierenden Spindel, vorzugsweise einer automatischen Präzisionssägemaschine, montiert. Arbeitet man im Einblattbetrieb, werden die zur Herstellung eines Gitters erforderlichen Gräben 8 Schnitt für Schnitt durch Scannen des mit bis zu 30000U/min rotierenden Sägeblattes mit konstanter Vorschubgeschwindigkeit über den Scheibengrundkörper eingebracht. Mit gegenwärtig kommerziell erhältlichen Sägemaschinen sind minimale Schnittiefen und Schnittabstände bis 0,1µm mit einer Wiederholungsgenauigkeit von ±1µm möglich. Der Winkel, den zwei aufeinanderfolgende Schnitte einschließen können, kann zwischen 0° und 90° mit einer Genauigkeit ±0.001° eingestellt werden. Die Vorschubgeschwindigkeit des Sägeblattes während des Scanvorganges kann bis zu 300mm/s betragen. Materialien, zu deren Bearbeitung gegenwärtig Sägeblätter angeboten werden, fallen in die große Klasse der kurzspanenden Werkstoffe. Dies sind alle gängigen Halbleitermaterialien, insbesondere Silizium, Keramiken, Ferrite, Gläser, Edelsteine und alle kurzspanenden Metalle wie Molybdän, Titan, usw.. Ferner werden neben Trennsägeblättern mit abgeflachtem Profil (Spitzenwinkel (siehe Abb. 1): 180°) V-förmig angespitzt Sägeblätter angeboten, wobei deren Spitzenwinkel γ über einen weiten Winkelbereich frei wählbar ist. Die kommerziell erhältlichen Trennsägeblätter haben minimale Dicken bis 7µm, während gegenwärtig profilierte Sägeblätter mit Dicken bis minimal 100µm erwerbbar sind. Zur Steigerung des Durchsatzes bei der Herstellung wird das Mehrblattverfahren angewendet, bei dem bis zu 100 Sägeblätter auf einer Spindel montiert sind.
d) Bei Durchführung des Verfahrens mittels Strukturierungswalzen wird ein walzenartiger Grundkörper optional mittels feinmechanischer Methoden über den gesamten Umfang und die ganze Walzenlänge mit dem Negativprofil der späteren Gitterstruktur versehen und anschließend mit Schleifmittelkörnern (z.B. bestehend aus Diamant, Bornitrid, Siliziumcarbid, usw.) überzogen. Als Ausgangsmaterial für den Grundkörper eignen sich Metalle (z.B. weiche Stähle, Aluminium, Bronze, usw.) aber auch Keramiken und Spezialkunststoffe. Eine direkte Herstellung der Strukturwalze aus dem entsprechenden Abriebmittel ist ebenfalls möglich.

Fig. 2 zeigt Schnittzeichnungen einer Strukturwalze mit einem Negativprofil, bestehend aus V-förmigen Rillen. Die Strukturwalze 2a kann auf dem Flansch einer schnell rotierenden Spindel montiert werden. Eine Strukturwalze mit einem massiven Grundkörper gemäß Fig. 2b wäre direkt über zwei Aufhängungspunkten mit der Antriebseinheit eines schnell rotierenden Motors zu verbinden. Zur Erzeugung der V-förmigen Rillen bzw. der Negativprofile in den Strukturwalzen allgemein bietet sich das von Bier et al. [KFK-Nachr. Jahrg. 23 2-3/91, S. 165-173] entwickelte Diamantfräsverfahren zur mikromechanischen Bearbeitung von Metallkörpern an, bei dem mit Hilfe eines hoch präzise geschliffenen Diamanten, der auf einem CNC gesteuerten XYZ-Tisch montiert ist, in einen schnell rotierenden Metallkörper Strukturen im Bereich von bis zu minimal 10µm eingefräst werden. Die so profilierte Metallwalze wird anschließend mit Scheifmittelkörner beschichtet. Dies kann unter Anwendung kommerzieller Technik auf elektrochemischen Wege geschehen, wobei eine mehrere zehn Mikrometer dicke Schicht bestehend aus Diamantpulver, welches in einer Bindemittelmatrix (z.B. Nickel) eingebettet ist, aufgetragen wird. Eine Beschichtung mittels Sinterverfahren ist ebenfalls denkbar. Auf eine schnell rotierende Spindel gespannt, könnte man mit einer entsprechend langen Strukturierungswalze in einem einzigen Arbeitsschritt eine Seite eines Gitters strukturiert werden, wie schematisch in Fig. 3 dargestellt.

In Fig. 4 ist eine Strukturwalze dargestellt, die aus einem unprofilierten, glatten Metallgrundkörper besteht, der mit einer Schleifmittelschicht überzogen ist. Diese Art Strukturwalze ist besonders zur Bearbeitung von kostengünstigen bandgegossenen Siliziumscheiben geeignet.

Bei Verwendung derartig hergestellter Silziumscheiben bzw. - bänder (z.B. Bayer RGS oder S-Web Silizium) für die industrielle Solarzellenproduktion treten Probleme aufgrund der relativ unebenen Oberfläche und der Oberflächenbeschaffenheit (Kontamination oberflächennaher Schichten mit Verunreinigungen und relativ dicke Siliziumoxidschichten an der Oberseite der Scheiben) auf. Führt man die mechanischen Strukturierung mit einer unprofilierten Walze aus, so wird eine Planarisierung der Oberfläche bei gleichzeitiger Entfernung eines Siliziumoxidbelages und kontaminierter oberflächennaher Schichten erzielt. Damit sind die genannten Probleme vermieden und es ist eine Steigerung der Qualität von im Bandgußverfahren hergestellten Siliziumscheiben erreicht.

### Beispiel 2

### Verwendung des erfindungsgemäßen Bauelements als Hochleistungssolarzelle

Nachfolgend werden drei Ausführungsvarianten I, II und III zur Verwendung des erfindungsgemäßen Bauelements als Hochleistungssolarzelle illustriert. Zum besseren Verständnis wird zunächst das Herstellungsverfahren erläutert, das für alle drei Ausführungsvarianten sehr ähnlich ist.

Als Ausgangsmaterial für den Herstellungsprozeß der Solarzelle dienen kristalline Siliziumscheiben (mono-, multi- oder polykristalline), wobei deren Größe, Oberflächenbeschaffenheit und Materialqualität keinen besonderen Anforderungen genügen müssen. Prinzipiell können prozessiert werden:
- monokristalline Siliziumscheiben,
- Wafer, gesägt aus gegossenen Siliziumblöcken,
- multikristalline Silizium-Bänder, hergestellt durch Abscheiden aus einer Siliziumschmelze auf einem Graphitnetz,
- multikristalline Si-Scheiben, die durch Abscheiden von flüssigem Silizium auf Graphitplatten unter Verwendung eines Gießrahmens erhalten werden.

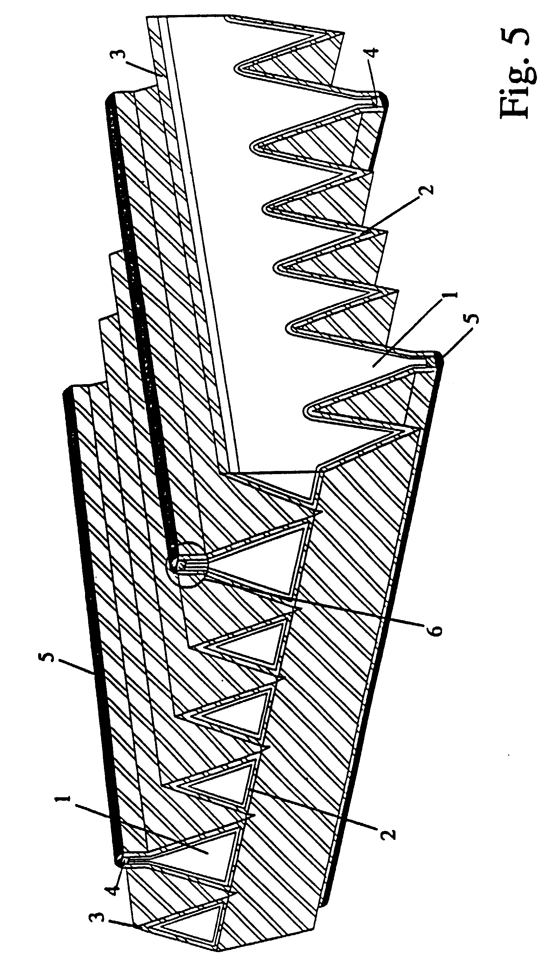

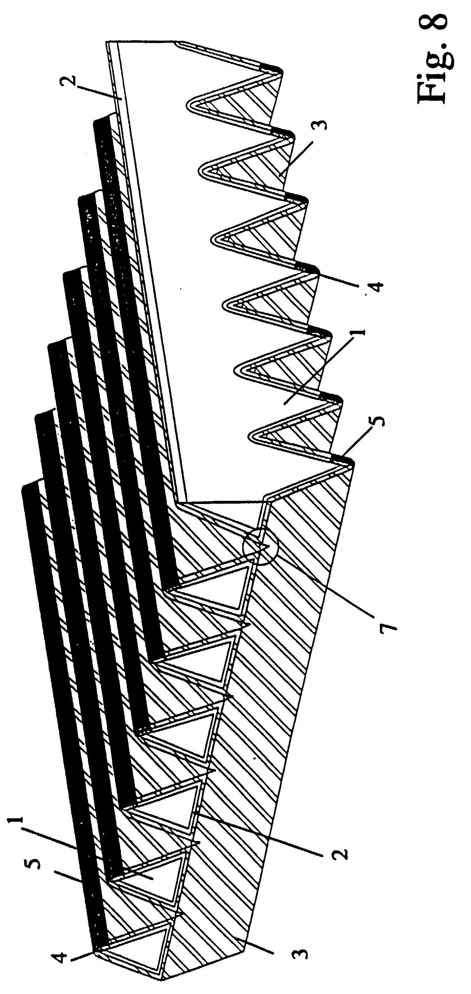

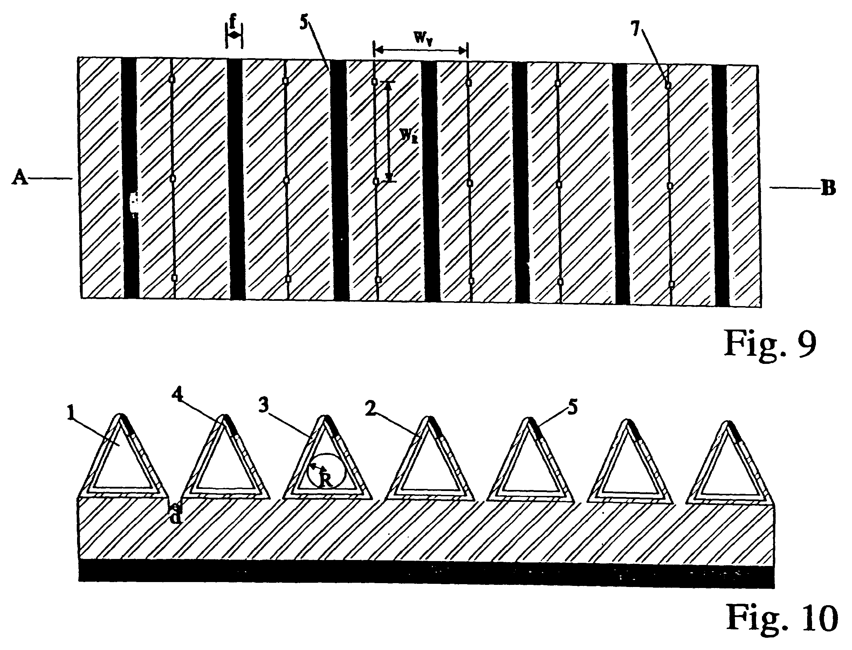

Im ersten Prozeßschritt werden auf beiden Seiten der vorliegenden Siliziumplatte V-förmige, zwischen Vorder- und Rückseite unter einem Winkel zueinander angeordnete Gräben 8 (bevorzugt 90°), mit Hilfe eines schnell rotierenden, mit angeschrägten Profilen versehenen Säge-Formkörpers (z. B. mit spitz zulaufenden Diamantsägeblättern, montiert auf einer konventionellen Siliziumscheibensäge, oder einer Strukturierungswalze) erzeugt. Die Tiefe der Gräben 8 hängt ab von
- der Dicke der zu bearbeitenden Siliziumscheibe,
- den Grabenabständen W_{R} und W_{V} (Fig. 6, Fig. 9) und dem Grabenwinkel GAMMA (Fig.7) und
- der Größe der die Vorder- und Rückseite verbindenden Löcher 7 (Fig. 5-11).

Beispielsweise werden bei 250µm dicken Si-Wafern 80µm dicke Sägeblätter, montiert auf einer Siliziumscheibensäge, mit einem Spitzenwinkel GAMMA von 35° und typischen Grabenabständen W_{R} und W_{V} von ca. 100µm und Grabentiefen von ca. 130µm verwendet.

Um die in den Ausführungsvarianten I und III erforderlichen Siliziumstege 6 zu erzeugen, wird zwischen zwei aufeinanderfolgenden Gräben 8, welche den Steg einschließen, im Vergleich zu den angrenzenden Gräben 8 der Abstand W_{V} bzw. W_{R} vergrößert.

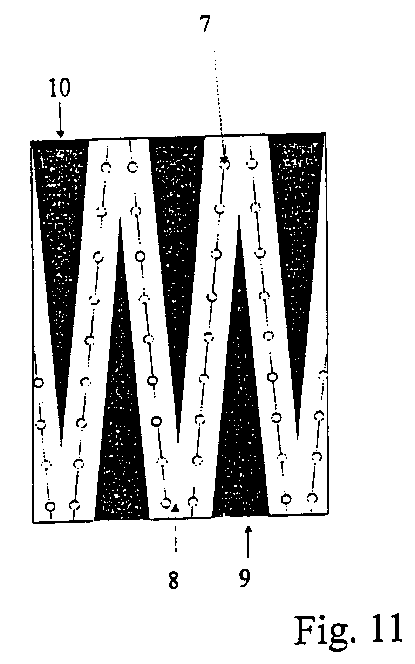

Um die am Ende der Solarzellenprozessierung erforderliche getrennte elektrische Verbindung der n-Typ- und p-Typ- Kontaktfinger 5 in Ausführungsvariante III zu vereinfachen, wird eine Strukturierung der Rückseite der Solarzelle gemäß Fig.11 vorgeschlagen. Diese Kontaktfingeranordnung wird dadurch erhalten, daß man zunächst parallel zueinander verlaufende V-Gräben 8 einbringt. Anschließend wird in einem folgenden Strukturierungsschritt ein zweiter Satz paralleler Gräben 8 erzeugt, wobei die Richtung der im ersten Strukturierungsschritt erzeugten Gräben 8 einen kleinen Winkel zu den Gräben 8 des zweiten Strukturierungsschrittes einschließt. Bei der in einem der folgenden Prozeßschritte durchgeführten Kontaktfingerdiffusionen werden die lateral spitz zulaufenden Siliziumstege 9 der einen Seite mit einer n⁺⁺ Diffusion versehen und der gegenüberliegende Satz von Stegen 10 mit einer p⁺⁺ Diffusion. Dadurch wird eine für Rückkontakt-Solarzellen vorteilhafte Kontaktfingeranordnung von ineinander verzahnten Kontakten alternierenden Ladungsträgertypes (n⁺⁺-p⁺⁺-n⁺⁺) erzielt. Ferner wird die elektrische Verbindung der einzelnen Kontaktfinger 5 gleichen Ladungsträgertypes mittels Aufbringen einer Hauptleiterbahn am jeweils äußeren Rand der Rückseite der Solarzelle bei der vorliegenden Kontaktfingeranordnung stark vereinfacht.

Als optionalen, folgenden Verfahrensschritt kann man eine Behandlung des gesägten Si-Substrates in einem sogenannten "damage getter"-Schritt möglicherweise in Verbindung mit Phosphor ("Phosphor-Gettering") durchführen, mit dem in der Einleitung erwähnten Effekt der Steigerung der Minoritätsladungsträger-Diffusionslänge.

Die durch das Herstellen der Gräben 8 im Silizium induzierten Defekte werden in einem anschließenden Ätzschritt entfernt. Mit Hilfe einer Ätzlösung mit polierender Wirkung wird eine von der Korngröße des verwendeten Abriebmittels abhängige typischerweise 10-20µm dicke Schicht auf beiden Seiten der gesägten Siliziumscheibe abgeätzt. Als Ätzmittel kommen sowohl Sauregemische (z.B. Flußsäure HF(50%)-Salpetersäure HNO₃(70%)- Essigsäure CH₃COOH(100%) mit einem Volumenverhältnis von 3:43:7, Ätzdauer 7-13min) in Frage als auch alkalische Lösungen (z.B. KOH- oder NaOH-Lösungen).

Der Emitter 2 der Solarzelle wird ganzflächig durch Phosphordiffusion auf beiden Seiten des Siliziummaterials 1 ( in diesem Fall p-dotiert) erzeugt. Die Bevorzugung von p-leitenden Siliziumscheiben gegenüber n-dotiertem Ausgangsmaterial beruht auf der einfacheren Herstellung sowie besseren Oberflächenpassivierung von diffundierten n-Schichten.

Als folgenden Prozeßschritt schließt sich eine thermische Oxydierung des Siliziummaterials zur Passivierung der Oberflächendefekte an. Von der dabei erhaltenen Oxidschicht 3 kann bei erfolgter Schichtdicken-Optimierung auch ein Antireflexionseffekt erzielt werden. Wahlweise kann der thermischen Oxidation eine ganzflächige Beschichtung mit Nitriden (z.B. SiN) folgen. Man erhält dadurch eine wirksamere Antireflexschicht im Vergleich zum Siliziumoxid und eine effiziente Diffusionsbarriere bei der folgenden starken n- und p-Diffusion für die Emitter- und Basiskontaktregionen.

Zur Kontaktierung der Solarzelle müssen nun die Regionen der Solarzelle von Siliziumoxid/Nitrid befreit werden, die später metallisiert werden sollen.

Diese Kontaktierung kann auf verschieden Art und Weise erfolgen, wie anhand der Ausführungsvarianten I, II und III auszugsweise dargestellt.

Bei Ausführungsvariante I wird dafür das Oxid 3 bzw. die Oxid- und Antireflexschicht auf der Oberseite der herausragenden Siliziumstege 6 entfernt. Dies kann zum einen mittels eines mechanischen Poliervorgangs erfolgen, zum anderen durch Auffüllen der Gräben 8 durch ein ätzresistentes Mittel und anschließendem Entfernen des Oxids 3 (bzw. Nitrids) mit Hilfe von entsprechenden Ätzlösungen geschehen.

Bei Ausführungsvariante II erfolgt das Öffnen der Kontaktfingerregionen mittels photolithographischer Prozeßschritte. An der Zelle werden anschließend Diffusionsvorgänge mit hoher Dotandenkonzentration durchgeführt, auf der einen Seite eine starke n⁺⁺-Diffusion (selektiver Emitter 2 ) und auf der anderen eine p⁺⁺-Diffusion (Basis). Dabei wird lokal in den von Oxid 3 befreiten Kontaktregionen 4 eine n⁺⁺- bzw. p⁺⁺-Schicht erzeugt, wobei der eigentliche Hochtemperatur-Diffusionsschritt gleichzeitig erfolgen kann. Der Rest der Solarzellenoberfläche ist durch das thermische Oxid 3 oder gegebenenfalls Siliziumnitrid gegen unerwünschte Eindiffusion der Dotanden in den darunterliegenden Emitter 2 geschützt.

Die Fingermetallisierung kann nun durch stromloses Plattieren (z.B. Pd-Ni, Pd-Ni-Cu, Pd-Ni-Ag usw.) hergestellt werden.

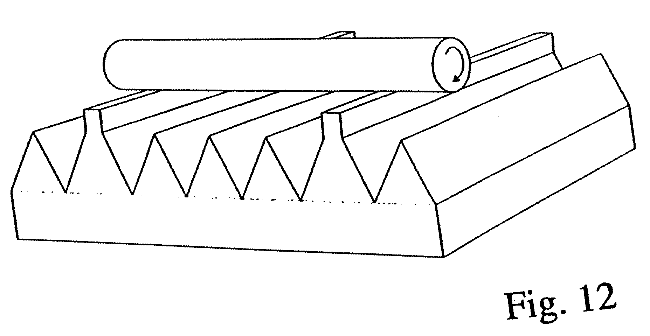

Ein weiteres, auf der in Fig. 5 gezeigten Solarzellenstruktur aufbauendes Metallisierungskonzept ist das in Fig. 12 dargestellte Walzendruckverfahren , das der Siebdrucktechnologie sehr verwandt ist. Dabei wird direkt auf die hervorstehenden Siliziumstege 6 unter Verwendung einer Walze (bevorzugt Hartgummi) metallhaltige Paste, die der beim Siebdruck verwendeten entspricht, aufgerollt und entsprechend weiterprozessiert. Vorteilhaft bei diesem Verfahren sind die mögliche Herstellung feinster Kontaktfinger 5 , leichte Übertragung auf industrielle Solarzellenprozessierung sowie die Nähe zu der industriell erprobten Siebdrucktechnologie.

Zum Abschluß erfolgt die Verbindung der Kontaktfinger 5 sowie die Zellenverschaltung. Man erhält dies beispielsweise bei Verwendung einer lötfähigen Fingermetallisierung durch Auflöten von Verbinderstreifen, die gleichzeitig den sogenannten "busbar" darstellen.

Die gängigen Methoden zur Erzeugung der Kontaktfingermetallisierung einer kristallinen Solarzelle, nämlich
- das Aufdampfen oder Aufsputtern einer Metallschicht oder einer Schichtenfolge gegebenenfalls in Verbindung mit photolithographischen Prozeßschritten [9],
- das Siebdruckverfahren zum Aufbringen einer mit Metallpartikeln versetzten Paste in Kombination mit einer folgenden Hitzebehandlung [7] und
- das stromlose Plattieren oder galvanische Abscheideverfahren zusammen mit zuvor ausgeführten photolithographischen Verfahrensschritten [11] oder laserunterstützte [6] oder mechanische Erzeugen von in die Zelle eingegrabenen Kontaktbahnen 5
sind nicht oder nur mit großem Aufwand auf die in Ausführungsvariante II vorgestellte Struktur anwendbar.

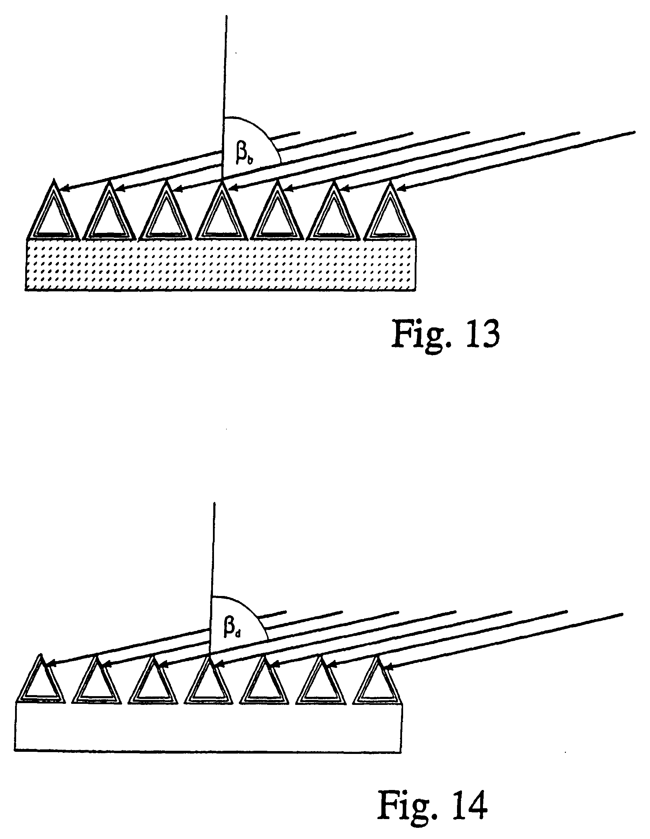

Erfindungsgemäß wird daher bei dieser Variante wie folgt verfahren:
Der Siliziumgrundkörper 1 wird nach den durchgeführten Prozeßschritten des Einbringens der V-förmigen Gräben 8 , des Ätzschrittes, der Herstellung des Emitters 2 und der thermischen Oxydation in einem Spin-, Tauch- oder Sprühvorgang mit einer Schicht von Positiv-Photolack überzogen. Die Zugrichtung während des Tauchvorganges sollte, um eine gleichmäßige Benetzung des Siliziumsubstrates zu erhalten, in einem Winkel von 45° zu der Grabenrichtung erfolgen. Nach durchgeführter Trocknung gemäß Herstellerangaben wird die Belichtung nach Fig. 13 in einem Leuchtfeld homogener Intensitätsverteilung vollzogen. Der Winkel (BETA) β_{b} kann je nach gewünschter Breite der Kontaktfinger 5 in einem Bereich zwischen 90-GAMMA/2 (GAMMA/2: halber Grabenspitzenwinkel) und 90° gewählt werden. Der schräge Lichteinfall bewirkt, daß nur ein schmaler Streifen an der Oberseite einer Grabenflanke belichtet wird, da die in Strahlrichtung vorgelagerten Gräben 8 die folgenden beschatten. Den gleichen Belichtungsvorgang hat man auf der gegenüberliegenden Solarzellenseite auszuführen. Die belichtete Fläche des Photolackes wird nun nach Angaben des Herstellers entfernt. Mit dem unbelichteten Photolack als Ätzstop wird dann der Teil der Solarzellenfläche, der später mit Metallen beschichtet werden soll, von thermischem Oxid 3 unter Verwendung von Flußsäure enthaltenden Ätzlösungen befreit. Vor der Fingermetallisierung erfolgt eine selektive Diffusion in der Kontaktzone 4, bei welcher auf einer Seite der Solarzelle ein n⁺⁺-dotierter Kontaktbereich hergestellt wird, auf der gegenüberliegenden ein p++-dotierter Bereich. Anschließend wird nach einem optionalen Ätzschritt die Metallbeschichtung durchgeführt. Zum einen kann dies durch ein Plattierungsverfahren erfolgen, wobei der Effekt der selektiven Abscheidung von Nickel aus wäßrigen Salzlösungen auf von Oxid befreitem Silizium ausgenutzt wird und man somit nur auf den Flächen der Solarzelle Metallabscheidungen erhält, auf denen zuvor das thermische SiO₂ entfernt wurde. Die gewünschte Dicke der Ni-Schicht kann je nach Verweildauer im Plattierungsbad relativ frei gewählt werden. Es ist möglich, der chemischen Vernickelung zum Verbessern der elektrischen Leitfähigkeitseigenschaften der Kontaktfinger 5 einen Kupferplattierungsvorgang oder ein Versilbern der vernickelten Flächen anzuschließen. Als alternatives Metallisierungsverfahren kommt auch Metallaufdampfen in Frage. Der Siliziumgrundkörper 1 ist dabei ähnlich dem Belichtungsvorgang des Photolackes gegenüber der Aufdampfrichtung zu verkippen (Fig. 13). Um eine befriedigende Metallisierung der Kontaktfinger 5 zu erhalten, sollte der Winkel (BETA) β_{d} zwischen der Flächennormale der Solarzelle und der Aufdampfrichtung gleich oder etwas kleiner als der Belichtungswinkel (BETA) β_{b} (Fig. 12) sein. Als weitere Möglichkeit kann eine ganzflächige Beschichtung der Zelloberfläche mit dem Kontaktmetall durchgeführt werden, welche bei einer folgenden Behandlung mit Aceton in einem Lift-Off Schritt an all den Stellen entfernt wird, an denen sich noch Photolack befand. Je nach gewählten Beschichtungsverfahren kann eine Wärmebehandlung zum Eintempern der Kontakte angeschlossen werden. Abschließend werden die Metallfinger nach dem zuvor beschriebenen Herstellungsprozeß durch eine Hauptleiterbahn ("Busbar") verbunden. Hat man als Metallisierungsmethode das Plattieren gewählt, so kann dieser Vorgang in den Herstellungsprozeß der Kontaktfinger in 5 integriert werden. Hierfür belichtet man nach erfolgter schräger Bestrahlung des Photolackes bei nun senkrechtem Lichteinfall mit Hilfe einer Streifenmaske einen der Zellgröße entsprechend breiten Streifen des Photolackes orthogonal zur Richtung der Kontaktfinger 5.

Das vorgestellte Verfahren hat zum einen den Vorteil, daß sowohl das Auftragen des Photolackes einfach zu handhaben ist als auch der Belichtungsvorgang durch das Wegfallen der Justierung von photolithographischen Masken sehr erleichtert wird.

### Funktionsweise der erfindungsgemäßen Solarzelle:

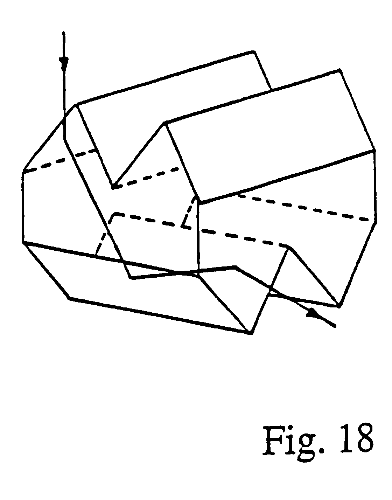

Fällt Licht auf die Solarzelle, so wird es durch das V-förmige Profil der Gräben 8 auf der Oberfläche der Solarzelle sehr effizient in diese eingekoppelt. Dies beruht sowohl auf Mehrfachreflexionen der einfallenden Strahlung an den Grabenwänden als auch auf einer Ablenkung des in die Solarzelle transmittierten Strahlungsanteils von der senkrechten Einfallsrichtung, wodurch dieser durch Unterschreitung des Grenzwinkels der Totalreflexion sehr wirksam im Innern der Solarzelle eingefangen wird (siehe hierzu Fig. 18).

Anhand von Fig.18 wird der Strahlengang mit auf der Vorder- und Rückseite unter einem Winkel zueinander angeordneten V-Gräben veranschaulicht - wobei aus Gründen der Deutlichkeit die erfindungsgemäßen Löcher weggelassen sind. Im allgemeinen gilt, daß ein Strahl langweiligen Lichtes vom Solarzellenmaterial nur schlecht absorbiert und in einer konventionellen Solarzelle nach zweimaligem Durchlaufen der Zelldicke, bei Reflexion an der metallisierten (d.h. verspiegelten) Rückseite, an der Vorderseite wieder ausgekoppelt wird. Bei der hier vorgestellten Struktur wird der senkrecht zueinander angeordneten V-Gräben der eingekoppelte Lichtstrahl auf der Rückseite der Zelle aus der Einfallsebene ausgelenkt, wie schematisch dargestellt, trifft danach auf eine weitere Rückseitenfläche und legt somit einen relativ langen Weg in der Solarzelle zurück, was die Absorptionswahrscheinlichkeit und somit die Empfindlichkeit der Zelle im Infraroten wesentlich erhöht.

Optische Verluste treten zum einen bei senkrechtem Lichteinfall durch die bei der vorgestellten Struktur vorhandenen Löcher 7 auf, zum anderen in Ausführungsvariante I durch Reflexionsverluste an den Kontaktfingern 5. Bei einem Grabenabstand von 100µm mit 5µm (20µm) Lochkantenlänge d beträgt der Anteil der von den Löchern 7 bedeckten Fläche 0,25% (4%). Die durch die Kontaktmetallisierung bei Ausführungsvariante I optisch unsensible Fläche läßt sich wie folgt abschätzen: Bei Annahme eines Kontaktstegabstandes a (Fig. 6) von 400µm und einer Stegbreite f von 10µm ergibt sich ein Verhältnis der mit Metall überzogenen Fläche zur Gesamtfläche von 2,5%. In Ausführungsvariante II treten an den Kontaktfingern 5 keine Einbußen an Lichtleistung auf, da die einfallende Strahlung dort direkt in den angrenzenden Graben 8 hineinreflektiert wird und zur Erzeugung elektrischer Leistung eingefangen werden kann. Aufgrund der vollständigen Anordnung der Kontaktfinger bei der Rückseiten-Solarzellenvariante von Ausführungsbeispiel III sind keine Beschattungsverluste aufgrund der Zellmetallisierung zu erwarten. Verkippt man die Flächennormale der Solarzelle zur Einfallsrichtung des senkrecht eingestrahlten Lichtes um mehr als die Hälfte des Grabenspitzenwinkels γ parallel zur Richtung der dem Licht zugewandten Gräben 8, so ist der Lichtdurchgang durch die Löcher 7 im Grundkörper, der die teilweise optische Transparenz bewirkt, weitgehend unterbunden.

Aufgrund der relativ kleinen optischen Verluste in Kombination mit der für einen effizienten Lichteinfang günstigen Grabenstruktur wird es möglich, daß ein Großteil des einfallenden Sonnenlichtes im Wellenlängenbereich kleiner 1200nm durch die Solarzelle absorbiert wird. Dabei werden im Silizium Ladungsträger (Elektronen und Defektelektronen) generiert. Im p-dotierten Grundsubstrat 1, das den Hauptanteil des Volumens der Solarzelle ausfüllt, diffundieren die dort erzeugten Minoritätsladungsträger, Elektronen, zum Emitter 2. Aufgrund des günstigen geometrischen Zuschnittes der vorliegenden Zellenstruktur sowie der fast ganzflächigen Ausbildung des Emitters 2 müssen dabei Entfernungen R (Fig. 10) von weniger als z.B. 35µm überwunden werden. Bei gängigen Diffusionslängen in multikristallinem Silizium von 40µm ist eine hohe Ausbeute bei der Einsammlung der generierten Ladungsträger zu erwarten. Eine weitere Eigenschaft der vorgestellten Solarzelle, die dies unterstützt, ist die fast ganzflächige Passivierung der Oberfläche mittels thermischem Siliziumoxid 3 und die damit verbundene Herabsetzung der Oberflächenrekombinationsgeschwindigkeit s. Ein kleiner Wert für s über fast das gesamte Äußere wirkt sich positiv in Hinblick auf eine hohe offene Klemmspannung der beleuchteten Zelle aus.

Die zur Emitterfläche gelangten Elektronen werden nun über die Metallfinger 5 , die sich über einer n⁺⁺-Dotierungszone 4 befinden, und die Hauptleiterbahn an einen äußeren Kreis abgeleitet. Dabei muß der Teil der Elektronen, welcher auf der der n⁺⁺-Kontaktzone gegenüberliegenden Zellenseite generiert wurde, durch die die beiden Seiten elektrisch verbindenden Löcher 7 fließen. Dies ähnelt einem Prinzip, das man bei der Polka-Dot-Solarzelle [9], die auf monokristallinem Silizium mit Hilfe photolithographischer Verfahren hergestellt wurde, anwandte.

### Beispiel 3:

### Verwendung des erfindungsgemäß Bauelements zur Grenzschichtbeeinflussung eines Köpers in einer Strömung, am Beispiel des Tragflächenprofils eines Flugzeugs:

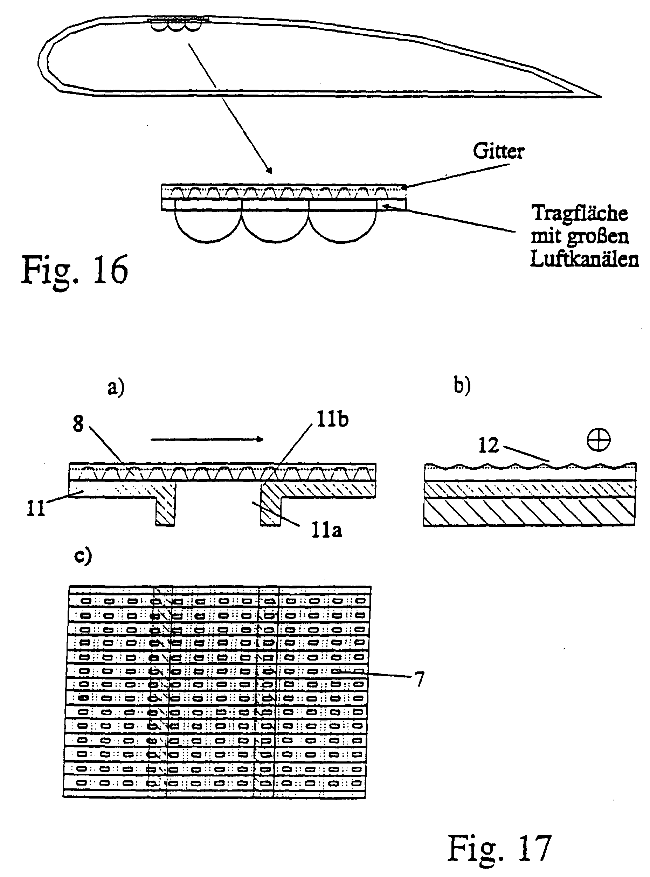

Mit dem erfindungsgemäßen Gitterelement wird die Oberfläche eines Flugzeugtragflügels beschichtet (Fig. 16). Das Gitter selbst hat keinerlei Tragwirkung, weshalb es aus beliebigen Materialien (Keramik, Kunststoff, Metall) hergestellt sein kann. Durch die Gitterlöcher 7 wird die Luftgrenzschicht an der Oberfläche des Tragflügels abgesaugt und damit eine Wirbelbildung vermieden, wodurch wiederum die Luftwiderstandskraft vorteilhaft reduziert wird und damit die Wirtschaftlichkeit ( niedrigerer Kraftstoffverbrauch, größerer Lastaufnahmekapazität) erhöht.

Die auf der umströmten Seite befindlichen, in einen Grundkörper (11) eingearbeiteten gesägten Strukturen 12 sind in Strömungsrichtung ausgerichtet (Fig. 17b). Die Kanäle 8 verlaufen auf der zum Tragflächenprofil ausgerichteten quer zur Strömungsrichtung und dienen als Sammelleitungen für große Absaugöffnungen 11b, die zu großen Absaugleitungen 11a führen, welche in der Tragfläche integriert sind (Fig. 17 a,c). Durch geeignete Dimensionierung der Löcher 7 kann ein Druckverlust über die Länge eines gesägten Kanals ausgeglichen werden. Durch die Wahl eines stumpfen Winkels des V-profilierten Sägeblatts für die Oberseite der Grenzflächen kann die Oberflächenvergrößerung gering gehalten werden. Die Löcher 7, welche durch das Sägeprinzip entstehen können beliebig dimensioniert werden. Die Abstände zwischen den Löchern 7 können sowohl in Strömungsrichtung (Fig. 17 a, Pfeil)) als auch quer zur Strömungsrichtung variiert werden und dem jeweiligen Problem angepaßt werden. Durch eine geringe Wandstärke der verbleibenden Struktur läßt sich diese an schwache Krümmungsradien leicht anpassen.

### Beispiel 4:

### Verwendung des erfindungsgemäßen Bauelements als Gitter zur Beschleunigung geladener Teilchen:

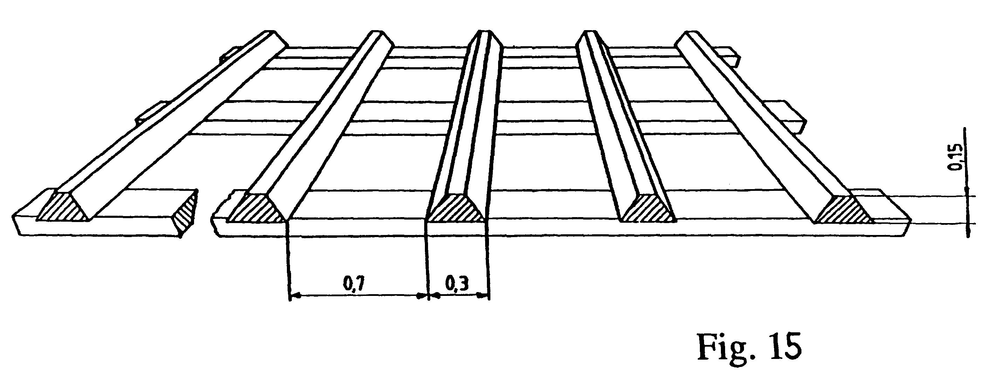

Anhand von Fig. 15 wird eine Beispiel einer Ionenoptik in einer filamentlosen HF-Plasma-Ionenstrahlquelle aufgezeigt.

In einer solchen Quelle wird durch Hochfrequenzentladung eines zu ionisierenden Gases ein Plasma erzeugt, aus dem Ionen mit Hilfe einer sog. Siliziumhybridionenoptik, die aus zwei naßchemisch geätzten Siliziumgittern besteht, extrahiert und fokussiert werden. Das an das Plasma angrenzende Gitter ist positiv vorgespannt, das zweite direkt davor befindliche Gitter negativ. Ionen, die plasmaseitig in die Nähe von Gitteröffnungen kommen, werden durch das elektrische Feld zwischen beiden Gittern abgesaugt und beschleunigt. Durch die senkrecht zur Extraktionsrichtungweisende Komponente des elektrischen Feldes zwischen zwei sich gegenüberliegenden Löchern kann eine Fokussierung der durchtretenden Ionen stattfinden. Dieser Effekt wird durch die lage der Äquipotentialflächen, hier die Oberflächensegmente des Gitters, beeinflußt.

Um bei niedrigen Ionenenergien (typischerweise 100eV-800eV) hohe Strahlströme (im Bereich 1mA/cm²) zu erhalten, muß der Abstand der Gitter nach dem CHILD-LANGMUIR-Gesetz möglichst gering sein. Ist der Gitteranstand allerdings niedriger als die Gitterlochgröße, so entstehen ungewollt Leckströme. Außerdem nimmt mit abnehmender Lochgröße herstellungsbedingt auch die Transparenz ab. Üblicherweise beträgt - vgl. Fig. 15 - der Gitterabstand 0,3 mm bis 1mm bei Lochgrößen von 0,7 mm.

Die in Fig.15 schematisch dargestellten Gitter können statt der bisher naßchemisch hergestellten Siliziumgitter in der oben beschriebenen Ionenquelle verwendet werden. Ihre Herstellung zeichnet sich durch Einfachheit und niedrige Ausschußraten aus. Von Seiten des Ausgangsmaterials besteht keine Beschränkung auf polierte einkristalline Siliziumscheiben. Es ist genauso möglich, Gitter aus polykristallinen, nicht polierten Scheiben zu fertigen und zwar aus Materialien, die dem späteren Einsatz der Quelle angepaßt sind. Die Gestaltung der Äquipotentialflächen ist nicht wie bisher durch den Ätzprozeß auf bestimmte Gitterebenen beschränkt. Sowohl der Neigungswinkel als auch die Stegform können variiert werden.

### Bezugszeichen

- 1: Grundsubstrat
- 2: Emitter(schicht)
- 3: Oxidschicht
- 4: Dotierungszone
- 5: Kontaktfinger/ Kontaktbahn
- 6: Siliziumsteg
- 7: Löcher
- 8: Graben
- 9: n⁺⁺-dotierter Steg
- 10: p⁺⁺-dotierter Steg
- 11: Absaugöffnung (a); Absaugleitung (b)
- 12: gesägte Strukturen

### Referenzen

(1) R.F. Van Overstraeten, R.P. Mertens, Physics; Technology and Use of Photovoltaics, Adam Hilger, Bristol, 1986, Seiten 148-150
(2) M.A. Green, High Efficiency Silicon Solar Cells, Trans Tech Publications, Kensington, 1987, Seiten 208-213
(3) A. Wang, J. Zhao, M.A. Green, Appl. Phys. Lett. 57 (6), 1990, Seiten 602-604
(4) J. Wohlgemuth, A. Scheinine, Proc. 14th IEEE PVSC, San Diego, 1980, Seiten 151-153
(5) J.S. Culik, E.L. Jackson, A.M. Barnett, Proc. 20th IEEE PVSC, Kissimimee, 1990, Seiten 251-256
(6) 5. Narayanan, J. Zolper, F. Yun, S.R. Wenham, A.B. Sproul, C.M. Chong, M.A. Green, Proc. 20th IEEE PVSC, Kissimimee, 1990, Seiten 678-680
(7) T. Okuno, S. Moriuchi, K. Nakajimy, Y. Yokosawa, K. Okamoto, T. Nunoi, H. Sawai, Proc. 11th, EEC PVSEC, Montreux, 1992, Seiten 408ff
(8) G. Willeke, H. Nussbaumer, H. Bender, E. Bucher, Solar Energy Materials and Solar Cells 26, North-Holland, 1992, Seiten 345-356,
(9) R.N. Hall, T.J. Soltys, Proc. 14th IEEE PVSC, San Diego, 1980, pp. 550-553
(10) M.A. Green, High Efficiency Silicon Solar Cells, Trans Tech Publications, Kensington, 1987, Seiten 189-191, Seite 216
(11) M.A. Green, High Efficiency Silicon Solar Cells, Trans Tech Publications, Kensington, 1987, Seite 171

## Patentansprüche

1. Verfahren zur Herstellung eines flachen Bauelement mit einem Gitternetz von Durchgangslöchern, dadurch gekennzeichnet,
daß auf der Vorder- und Rückseite eines scheibenförmigen Grundkörpers je eine Vielzahl, vorzugsweise äquidistanter, paralleler, insbesondere V-förmiger Gräben (8) derart eingearbeitet werden, daß die Gräben (8) der beiden Seiten relativ zueinander einen Winkel einschließen und jeweils so tief sind, daß an den Kreuzungspunkten der Gräben (8) von Vorder- und Rückseite automatisch die Durchgangslöcher entstehen.

2. Verfahren nach Anspruch 1 dadurch gekennzeichnet,
daß die Gräben (8) mechanisch, insbesondere mittels eines schnell rotierenden, mit angeschrägten Profilen versehenen Sägeblattes, eingebracht werden.

3. Verfahren nach Anspruch 1, dadurch gekennzeichnet,
daß die Gräben (8) mechanisch, insbesondere mittels eines schnell rotierenden, aus einem walzenförmigen Metallgrundkörper bestehenden, das Negativprofil der Gräben (8) aufweisenden Sägeformkörpers, der mit einem Abriebmittel überzogen ist, eingebracht werden.

4. Verfahren nach Anspruch 3, dadurch gekennzeichnet,
daß der Sägeformkörper aus einem walzenförmigen Grundkörper besteht, der nicht aus Metall ist.

5. Flaches Bauelement mit einem Gitternetz von Durchgangslöchern (7), dadurch gekennzeichnet,
daß es nach dem Verfahren gemäß Anspruch 1 hergestellt ist, wobei die Durchgangslöcher (7) dadurch entstehen,
daß auf der Vorder- und Rückseite eines scheibenförmigen Grundkörpers je eine Vielzahl, vorzugsweise äquidistanter, paralleler, insbesondere V-förmiger Gräben (8) eingearbeitet sind, und daß die Gräben (8) der beiden Seiten relativ zueinander einen Winkel einschließen und jeweils so tief sind, daß an den Kreuzungspunkten der Gräben (8) automatisch die Durchgangslöcher (7) entstehen.

6. Bauelement nach Anspruch 5, dadurch gekennzeichnet,
daß mehrere Gitternetze übereinandergeschichtet sind.

7. Bauelement nach Anspruch 6, dadurch gekennzeichnet,
daß bei zwei oder mehreren der Gitternetze die Gräben (8) der Rückseite des vorhergehenden Gitters unter einem vorzugsweise senkrechten Winkel, relativ zur Ausrichtung der Gräben (8) auf der Vorderseite des nachfolgenden Gitters orientiert sind.

8. Bauelement nach Anspruch 6, dadurch gekennzeichnet,
daß bei zwei oder mehreren der Gitternetze die Gräben (8) der Rückseite des vorhergehenden Gitters parallel zu der Ausrichtung der Gräben (8) auf der Vorderseite des nachfolgenden Gitters orientiert sind, so daß die Gräben (8) des vorhergehenden Gitters den nachfolgenden Grabenspitzen als Führungsnuten dienen.

9. Bauelement nach einem der Ansprüche 6 bis 8, dadurch gekennzeichnet,
daß sich zwischen zwei oder mehreren Gitternetzen ein scheibenförmiger Grundkörper ohne Durchgangslöcher (7) befindet.

10. Bauelement nach Anspruch 6 oder 7 zur Verwendung als Mikrofilter, dadurch gekennzeichnet,
daß die Flußrichtung des zu filternden, flüssigen oder gasförmigen Mediums unter einem, vorzugsweise senkrechten, Winkel zur Gitterebene verläuft.

11. Bauelement nach Anspruch 6 oder 7 zur Verwendung als Mikrosieb, dadurch gekennzeichnet,
daß der Partikelfluß unter einem, vorzugsweise senkrechten, Winkel zur Gitterebene verläuft und daß der Durchmesser der Durchgangslöcher (7) der einzelnen Scheiben von der Vorder- zur Rückseite des Filters abnimmt, so daß bei einem Trägergas- oder Trägerflüssigkeitsfluß senkrecht zur Filterebene durch die entsprechenden Gräben (8) eine Selektion der Partikel nach Größe erfolgt.

12. Bauelement nach Anspruch 6 oder 7 zur Verwendung als Katalysatorgrundkörper, dadurch gekennzeichnet,
daß die Gitternetze aus der katalytisch wirksamen Substanz bestehen und/ oder mit dieser beschichtet sind.

13. Bauelement nach Anspruch 5 zur Verwendung als Gitter zur Beschleunigung geladener Teilchen.

14. Bauelement nach Anspruch 24, dadurch gekennzeichnet,
daß die Gräben (8) einen trapezförmigen Querschnitt aufweisen.

15. Bauelement nach Anspruch 13 oder 14, dadurch gekennzeichnet,
daß das Bauelement eine vorzugsweise sehr hohe Transparenz aufweist.

16. Verwendung des Bauelement nach Anspruch 10 zur Beeinflussung des Strömungsverhalten eines umströmten Körpers, wobei eine Absaugung oder Injektion eines Mediums mittels der Durchgangslöcher (7) und der Gräben (8) auf der dem Medium abgewandten Rückseite erfolgt.

17. Verwendung der Bauelemente nach einem der Ansprüche 5 bis 10
als Grundkörper zur Herstellung von Mikrokühlern und Mikrowärmetauschern.

18. Verwendung der Bauelemente nach einem der Ansprüche 5 bis 10
als Grundkörper für Gas-, Flüssigkeis- oder Partikelsensoren, wobei die Gräben als Justierhilfe zur Fixierung von optischen Glasfasern oder Mikrokanülen dienen.
